# EUROPEAN PATENT APPLICATION

(11) **EP 3 241 983 A1**
(43) Date of publication of application: **08.11.2017**
(21) Application number: 16167976.6
(22) Date of filing: 02.05.2016
(51) Int. Cl.: E21B 41/00, E21B 33/035, H05K 5/06

(54) **COMPARTMENT FOR A SUBSEA DEVICE**

(71) Applicant: Siemens Aktiengesellschaft, 80333 München (DE)
(72) Inventor: Volent, Kjetil Zsolt, 7022 Trondheim (NO)

(57) **Abstract**

A compartment (100) for a subsea device comprises:
- a pressure compensator (400) defining an inner enclosure (410) of the compartment (100), the inner enclosure (410) having a variable volume,
- wherein the inner enclosure (410) is suitable for housing at least an electrical or hydraulic component (200, 300) of the subsea device housed inside the inner volume (120).

## Description

### Field of invention

The present invention relates to a subsea device including a pressure compensation device for compensating volume variations of a liquid in a compartment of the subsea device.

### Art Background

Electronics and hydraulics components are often enclosed in pressurized compartments of subsea devices.
Such compartments provide advantages like:
- smaller and lighter enclosures are needed to accommodate the electronics and hydraulics components, due to the pressure difference between the inside and the outside of the compartment,
- better thermal control is possible.
The compartment is normally filled with a fluid medium (typically an oil) at a pressure greater than the see water pressure outside the compartment. To be able to maintain such pressure, a compensator is normally used.
A conventional pressure compensator according to the prior art may consist consists of a single bellow confining a compensation volume which is connected to the inner volume of a subsea compartment. In particular when using a formed metal bellow in the pressure compensator, the stroke of the bellow is rather limited, resulting in a large absolute volume of pressure compensator for a given volume variation that is to be achieved. Pressure compensator thus requires a lot of space and, due to its size, is relatively heavy. Therefore, it also needs to be filled with a large volume of liquid, for example oil.

### Summary of the Invention

It may be an object of the present invention to provide a compartment for a subsea device, which overcome the inconveniences above described.
It may be another object of the present invention to provide a compartment for a subsea device making a better use of the volume of a pressure compensator.
It may be a further object of the present invention to provide a compartment for a subsea device, which allows reducing the overall sizes of the compartment.

In order to achieve the objects defined above, a compartment for a subsea device and a subsea device according to the independent claims are provided. The dependent claims describe advantageous developments and modifications of the invention.

According to a first aspect of the present invention, compartment for a subsea device comprises:
- a pressure compensator defining an inner enclosure of the compartment, the inner enclosure having a variable volume,
- the inner enclosure being suitable for housing at least an electrical or hydraulic component of the subsea device housed inside the inner volume.

According to a second aspect of the present invention, a subsea device including the above described compartment is provided.

According to the present invention, an inner enclosure of the compartment can be used, at the same time:
- for hosting electrical or hydraulic components and
- as a pressure compensator.
In other words, the inner enclosure for hosting electrical or hydraulic components and the pressure compensator are integral with each other.
Advantageously, this determines in a subsea device where you a separate enclosure for hosting the electrical or hydraulic components is not needed. This in particular determines reduced overall dimensions of the compartment and, consequently:
Reduced enclosure size:
   - reduced costs
   - reduced complexity
   - reduced weight
   - easier installation and handling at the subsea location.

According to a possible exemplary embodiment of the present invention, the compartment further comprises an housing defining an inner volume of the compartment, the housing including at least a first passage for putting in communication the inner volume with a first fluid medium surrounding the compartment, the pressure compensator being arranged inside the inner volume. As an alternative embodiment, the compartment further comprises a plate to which the pressure compensator is constrained. In the latter embodiment the pressure compensator may be put in direct contact with the subsea environment and it is preferably double-walled.

According to possible exemplary embodiments of the present invention, the pressure compensator comprises at least a bellow. In particular the pressure compensator may comprise a metallic bellow.

According to possible exemplary embodiments of the present invention, the inner enclosure is delimited by the bellow and by a wall of the housing. This in particular permits to provide a housing of the compartment comprising at least a further passage for the electrical or hydraulic component to be connected with a respective electrical or optical or hydraulic source.
Advantageously, this makes it easier to connect the electrical or hydraulic components inside the pressure compensator. In particular, the compartment may comprise at least a connector or penetrator passing through the further passage for connecting the electrical or hydraulic component to the respective electrical or optical or hydraulic source.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawing

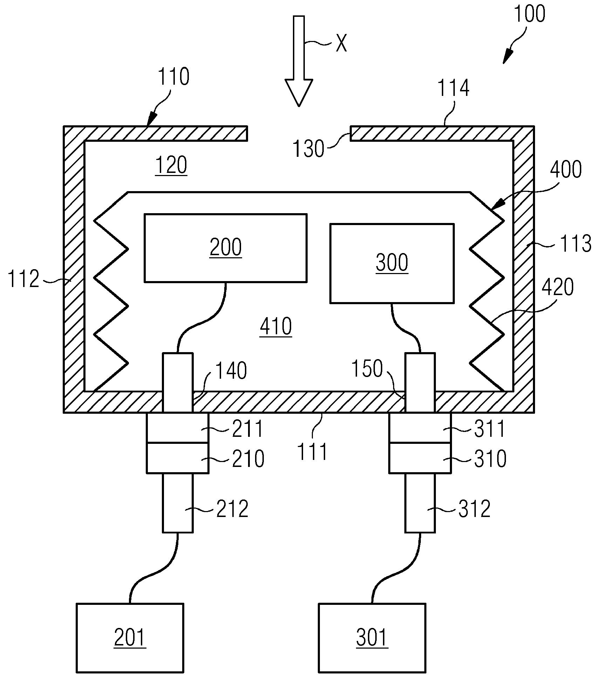

Fig. 1 shows a schematic sectional view of a compartment for a subsea device according to the present invention,

### Detailed Description

**Fig. 1** shows a possible embodiment of a compartment 100 for a subsea device, according to the present invention.
The compartment 100 comprises a housing 110 including a plurality of walls 111, 112, 113, 114. The housing 110 defines an inner volume 120 of the compartment 100 delimited by the walls 111, 112, 113, 114.
The housing 110 is rigid and the dimensions of the inner volume 120 are constant.
According to other possible embodiments (not shown) the housing 110 is deformable, for example comprising a bellow. One upper wall 114 of the housing 110 includes a first passage 130 for putting in communication the inner volume 120 of the compartment 100 with a first fluid medium surrounding the compartment 100.
When the compartment 100 is installed at a subsea location the first fluid medium is sea water. The sea water surrounding the compartment 100 is therefore free to enter the inner volume 120 through the first passage 130.
The compartment 100 further comprises a pressure compensator 400 arranged inside the inner volume 120 of the compartment 100. The pressure compensator 400 defines a liquid tight inner enclosure 410 having a variable volume.
In particular, the pressure compensator 400 may comprise one or more bellow, as shown in the attached figure, where one metal bellow 420 is linked to one lower wall 111 of the housing, opposite to the upper wall 114. A liquid tight seal (not shown) is provided between the metal bellow 420 and the lower wall 111.
The inner enclosure 410 is therefore delimited by the bellow 420 and by the lower wall 111 of the housing 110.
According to another possible embodiment (not shown), the housing 110 is not present and the pressure compensator 400 is in direct contact with the subsea environment. In such embodiment, the metal bellow 420 of the pressure compensator 400 is linked to a plate, equivalent to the lower wall 111 of the housing 110 and delimiting the inner enclosure 410. In such embodiment the pressure compensator 400 may be double-walled, to prevent damages to the inner enclosure 410, which may be caused by the direct contact with the subsea environment.

The inner enclosure 410 have dimensions suitable for housing at least an electrical or hydraulic component (one electrical component 200 and one hydraulic component 300 in the embodiment of the attached figure).
Examples of electronics which may be housed inside the inner enclosure 410 are:
- electronics connected to temperature sensors
- electronics connected to pressure sensors
- electronics connected to control modules.
Hydraulic components which may be housed inside the inner enclosure 410 are valves, gauges or directional control valves (DCV).

The inner enclosure 410 is filled with a second fluid medium, for example oil, at a pressure greater than the pressure of the first fluid medium surrounding the compartment 100. The components 200, 330 inside the inner enclosure 410 are made to be operable under such pressure. The pressure compensator 400 compensates for variations in the volume of the second fluid medium, which may occur due to variations in outside pressure and/or temperature. Temperature changes may be also caused by internal heating, e.g. due to electric losses of electrical component 200.
In the embodiment of the attached figure, a variation of the volume of the pressure compensator 400 occurs through a respective deformation of the bellow 420. The bellow 420 is oriented in such a way that the bellow 420 deforms along a deformation direction X which is parallel to two lateral walls 112, 113 of the housing 110 and orthogonal to the lower wall 111 and to the upper wall 114.
In the embodiment of the attached figure, the cross section of the inner enclosure 410, along a direction orthogonal to the deformation direction X, is defined by the cross section of the bellow 420. In particular, such cross section of the inner enclosure 410 may be constant.
The lower wall 111 of the housing 110 comprises at least a further passage (a second passage 140 and a third passage 150 in the embodiment of the attached figure) for letting the electrical or hydraulic component 200, 300 to be connected with a respective electrical or optical or hydraulic source 201, 301. The connection between components 200, 300 and the respective electrical or optical or hydraulic source 201, 301 passes through the lower wall 111 of the housing 110, i.e. the wall of the housing 110 which delimits also the inner enclosure 410. In particular, to allow such connections, the compartment 100 comprises respective connectors or penetrators 210, 310 passing through the passages 140, 150, respectively, and partially housed in the enclosure 410. Each of the connectors or penetrators 210, 310 comprises a respective first portion 210a, 310a and a respective second portion 210b, 310b.
The first portion 210a, 310a is respectively coupled to the passage 140, 150 in a liquid tight manner and protrudes in the inner enclosure 410. The second portion 210b, 310b is respectively connectable to the first portion 210a, 310a in a removable way, for establishing the connection between the electrical or hydraulic components 200, 300 and the sources 201, 301.

## Claims

1. A compartment (100) for a subsea device comprising:
- a pressure compensator (400) defining an inner enclosure (410) of the compartment (100), the inner enclosure (410) having a variable volume,
- wherein the inner enclosure (410) is suitable for housing at least an electrical or hydraulic component (200, 300) of the subsea device housed inside the inner volume (120).

2. The compartment (100) for a subsea device according to claim 1, wherein the compartment (100) further comprises an housing (110) defining an inner volume (120) of the compartment (100), the housing (110) including at least a first passage (130) for putting in communication the inner volume (120) with a first fluid medium surrounding the compartment (100), the pressure compensator (400) being arranged inside the inner volume (120).

3. The compartment (100) for a subsea device according to claim 1 or 2, wherein the compartment (100) further comprises a plate (111) to which the pressure compensator (400) is linked.

4. The compartment (100) for a subsea device according to any of the proceeding claims, wherein the pressure compensator (400) comprises at least a bellow (420).

5. The compartment (100) for a subsea device according to claim 4, wherein the inner enclosure (410) is delimited by the bellow (420) and by a wall (111) of the housing (110) or by the plate (111).

6. The compartment (100) for a subsea device according to any of the proceeding claims, wherein the housing (110) or the plate (111) comprises at least a further passage (140, 150) for the electrical or hydraulic component (200, 300) to be connected with a respective electrical or optical or hydraulic source (201, 301).

7. The compartment (100) for a subsea device according to claim 6, wherein the compartment (100) comprises at least a connector or penetrator (210, 310) passing through the further passage (140, 150) for connecting the electrical or hydraulic component (200, 300) to the respective electrical or optical or hydraulic source (201, 301).

8. The compartment (100) for a subsea device according to any of the proceeding claims, wherein the enclosure (410) is filled with a second fluid medium having a pressure greater than the pressure of the first fluid medium surrounding the compartment (100).

9. The compartment (100) for a subsea device according to claim 8, wherein the first fluid medium is sea water and the second fluid medium is an oil.

10. The compartment (100) for a subsea device according to claim 2, wherein the housing (110) is rigid and the dimensions of the inner volume (120) are constant.

11. The compartment (100) for a subsea device according to any of the proceeding claims, wherein the pressure compensator (400) is double-walled.

12. A subsea device comprising a compartment (100) according to any of the proceeding claims.

13. The subsea device of claim 12, wherein the subsea device further comprises at least an electrical or hydraulic component (200, 300) housed inside the inner volume (120) of the compartment (100).
